# EUROPEAN PATENT SPECIFICATION

(11) **EP 3 477 697 B1**
(45) Date of publication and mention of the grant of the patent: **05.08.2020**
(21) Application number: 17198678.9
(22) Date of filing: 26.10.2017
(51) Int. Cl.: H01L 23/38, H01L 35/32

(54) **ENERGY HARVESTER**
ENERGIESAMMLER
DISPOSITIF DE COLLECTE D'ÉNERGIE

(43) Date of publication of application: 01.05.2019
(73) Proprietor: Vestel Elektronik Sanayi ve Ticaret A.S., 45030 Manisa (TR)
(72) Inventor: ULUAG, Onur, 45030 Manisa (TR)
(74) Representative: Thomas, Michael Andrew

(56) References cited:
- EP-A1- 2 575 186
- FR-A1- 3 002 085
- JP-A- 2001 320 003
- US-A1- 2012 299 375
- US-A1- 2014 252 531
- US-A1- 2017 287 977
- US-B1- 6 196 002
- US-B1- 6 711 904

## Description

### Technical Field

The present disclosure relates to an energy harvester.

### Background

Heat generation by integrated circuits presents both a difficulty and an opportunity. The difficulty lies in removing excess heat from the integrated circuit packaging and various techniques are known for achieving this. The opportunity lies in generating electricity from the heat produced that may be used to reduce overall energy consumption of a product, or for energy storage.

For example, US2013/0134544A1 discloses an arrangement of copper/copper oxide pillars formed within an integrated circuit package extending from a high temperature region of the package to a low temperature region. A thermoelectric potential is created between the copper and copper oxide materials as a result of a temperature gradient between at high and low temperature ends of those conductors. This enables a current to flow which may be passed to capacitors embedded within the packaging substrate to store a corresponding electric charge with various potential uses for the integrated circuit.

US2002/0113289A1 discloses a fabrication method by which an integrated circuit is fabricated on one side of a substrate and a thermoelectric cooler is fabricated on the reverse side of the substrate for use in cooling the integrated circuit.

US2017287977A1 discloses integrated circuit devices which include a thermoelectric generator which recycles heat generated by operation of an integrated circuit, into electrical energy that is then used to help support the power requirements of that integrated circuit.

JP2001320003A discloses a semiconductor device. A thermoelectric conversion element converts heat energy that is generated to electric energy.

US2012299375A1 discloses an apparatus for cooling an electrical component in a vehicle. A power module includes a plurality of thermoelectric cells coupled to a printed circuit board for discharging heat away from an electrical component.

FR3002085A1 discloses a component, such as a mobile phone, which has a housing enclosing an electronic device, e.g. microprocessor, which generates heat during operation, and an energy conversion element, e.g. Seebeck element.

### Summary

According to an aspect disclosed herein, there is provided an energy harvester connected to receive an electric current output at respective conducting pins of an integrated circuit package by a thermoelectric structure incorporated therein, wherein:
the integrated circuit package comprises: a housing; an integrated circuit contained within the housing; the thermoelectric structure having a first face arranged in proximity to the integrated circuit within the housing and a second face arranged in thermal contact with ambient conditions; the electrically conducting pins extending outwardly from the housing and connected to the thermoelectric structure within the housing for conducting an electric current generated by the thermoelectric structure for use outside the package; and
the energy harvester comprises a controller configured to control a use made of the received electric current;
wherein the controller is configured to determine whether:
   (i) to use the received current to recharge an electrical energy storage device; or
   (ii) to use the received current as a supplementary source of electric current for operation of the integrated circuit package (10) or for another electronic device; or
   (iii) to supply previously stored energy from the electrical energy storage device; and
wherein the controller is configured to receive a sensed temperature indication from a temperature sensor associated with the integrated circuit package and, if the sensed temperature exceeds a predetermined upper limit, to trigger the supply of an electric current to the thermoelectric structure provided in the package via the respective conducting pins and thereby provide cooling of an integrated circuit incorporated within the package .

In this way a decision may be made by a centralised controller on whether to harvest energy from an integrated circuit package or to supply a current to help with cooling in the integrated circuit package.

An integrated circuit package providing access from outside the package to a generated thermoelectric current allows for central energy harvesting and centralised control of the redistribution of harvested energy. This is to the overall benefit of an electronic circuit, in particular to one incorporating multiple integrated circuits packaged in this way.

In an example, the thermoelectric structure comprises an arrangement of dissimilar electrically conducting materials of a first and a second type, wherein one or more portions of the first and second types of material extend between the first face and the second face of the structure, a portion of the first type of material being electrically coupled at the first face to a portion of the second type of material and the portions being electrically connected directly or indirectly to respective conducting pins at the second face.

A thermoelectric structure comprising dissimilar semiconductor materials exploits the Seebeck effect by which an electric current may be generated as a result of a temperature difference between a 'hot' junction of the semiconductors and a 'cold' point of connection to the semiconductors.

In an example implementation, the first type of material is a *p*-type semiconductor and the second type of material is an *n*-type semiconductor.

In an example configuration, two or more pairs of portions of the first and second types of material are connected in series at the second face to increase the generated voltage across the structure. Alternatively, or in addition, two or more pairs of portions of the first and second types of material are connected in parallel at the second face to increase the current flow available from the structure.

The thermoelectric structure may be used either for energy harvesting or, in the event of overheating of the integrated circuit, to assist with cooling. A temperature sensor enables a decision to be made on whether to harvest energy from heat generated by the integrated circuit or to assist with cooling of the integrated circuit.

In an example, the energy harvester is arranged to receive an electric current from a plurality of integrated circuit packages as described above according to the first aspect and the controller is configured to receive respective sensed temperature indications from a temperature sensor associated with at least one of the plurality of integrated circuit packages and to trigger the supply of harvested electrical energy to respective conducting pins of the at least one integrated circuit package if the indicated temperature exceeds the predetermined upper limit.

In this way, an energy harvester may operate to manage the harvesting of energy from multiple integrated circuit packages in an electronic circuit and make use of harvested energy in helping to cool any integrated circuit packages that begin to overheat. This has the potential to increase the overall operating efficiency and to reduce the overall energy consumption of the electronic circuit.

### Brief Description of the Drawings

To assist understanding of the present disclosure and to show how embodiments may be put into effect, reference is made by way of example to the accompanying drawings in which:
Figure 1 shows schematically a sectional view of a portion of an integrated circuit package according to the present disclosure; and
Figure 2 shows schematically a sectional view through a thermoelectric structure according to the present disclosure in close proximity with an integrated circuit.

### Detailed Description

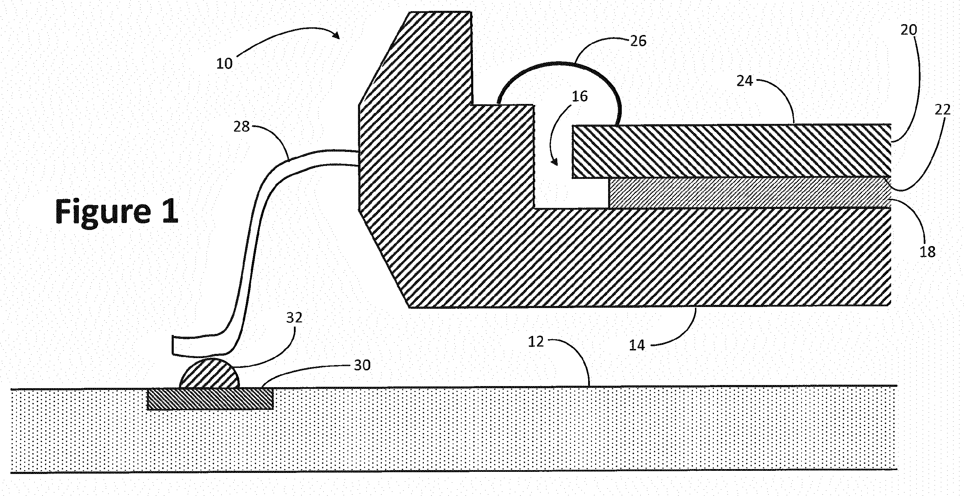

In an example to be described below with reference to Figure 1, a thermoelectric structure is incorporated into the packaging of an integrated circuit for the purposes of harvesting thermoelectric electricity generated as a result of heat generated by the integrated circuit.

Referring to Figure 1, a schematic sectional view is provided of a portion of an integrated circuit package according the present disclosure, mounted on a printed circuit board 12. The integrated circuit package comprises a housing of which only a base portion 14 is shown in Figure 1. The base portion 14 provides an internal recess 16 containing an integrated circuit 18 and a thermoelectric structure 20 in the form of a layer placed above and in contact with, or in close proximity to, the integrated circuit 18. When assembled the integrated circuit package 10 includes a lid or other encapsulating material, not shown in Figure 1, to enclose and protect the integrated circuit 18 and thermoelectric structure 20 within the recess 16.

The thermoelectric structure 20 is arranged to operate with a 'hot' face 22 in close proximity to the integrated circuit 18 and a 'cold' face 24 with a thermal link to ambient temperatures. During operation, heat emitted by the integrated circuit 18 causes a temperature difference between the hot face 22 and the cold face 24 of the structure 20 and hence an electric current to flow within the thermoelectric structure 20 when connected to a load, according to the Seebeck effect. The electric current may be conducted out of the package 10 by means of wires 26 (of which only one is shown in Figure 1) linking the thermoelectric structure 20 to conducting pins 28 (of which only one is shown in Figure 1) leading out of the package 10. The conducting pin 28 may be connected to a respective conducting track 30 formed on the printed circuit board 12 by means of a solder connection 32.

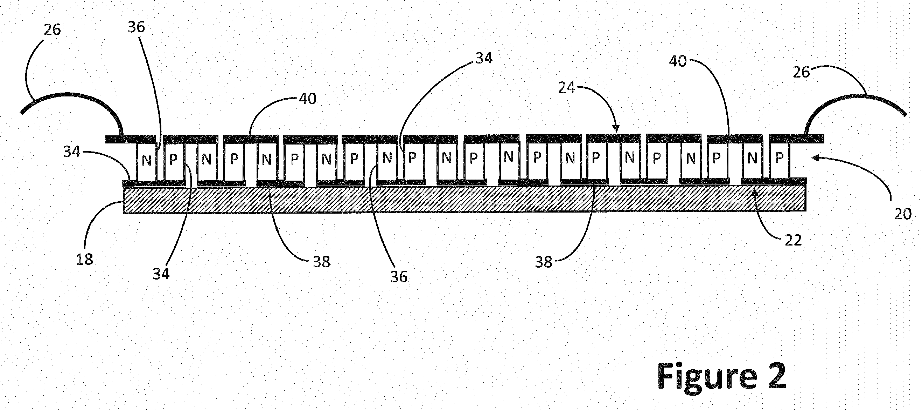

The thermoelectric structure 20 may be one of a number of known structures arranged to exploit the thermoelectric properties of dissimilar conductors. One example structure will now be described with reference to Figure 2.

Referring to Figure 2, an example thermoelectric structure 20 comprises a structure formed of portions, in this example in the form of substantially rectangular blocks 34, 36 of dissimilar semiconductor materials. The blocks 34, 36 are fabricated to comprise an arrangement of *p*-type semiconductor blocks 34 and *n*-type semiconductor blocks 36. The blocks 34, 36 are arranged in pairs, each pair comprising one block formed of each type of semiconductor material. The blocks 34, 36 in each pair are electrically coupled at the 'hot' face 22 of the structure 20 to form a 'hot' junction by respective electrodes 38. At the 'cold' face 24 of the structure 20, one block 34, 36 of each pair is electrically connected either to a respective link 26 and connecting pin 28 external to the package 10 or to one block 34, 36 of an adjacent pair by a respective electrode 40. Pairs of blocks 34, 36 may be connected in series, as shown in Figure 2 for the sectional view provided, to increase the thermoelectric voltage generated by the structure 20, or in parallel to increase the thermoelectric current. If connected in series, as in Figure 2, the *p*-type semiconductor block 34 of one pair is connected by the electrode 40 to the *n*-type semiconductor block 36 of an adjacent pair. If connected in parallel, the *p*-type and *n*-type semiconductor blocks 34, 36 of one pair are connected respectively by electrodes 40 to the *p*-type and *n*-type semiconductor blocks 34, 36 of an adjacent pair.

In operation, heat generated by the integrated circuit 18 causes a temperature difference between the junction at the 'hot' face 22 of the structure 20 and the 'cold' face 24. According to the Seebeck Effect, the temperature difference causes a corresponding electromotive force (emf) to be developed between the dissimilar conductors of each pair of blocks 34, 36 at the 'cold' face 24 of the structure 20. As a result, in this example, an electric current flows through each pair of semiconductor blocks 34, 36 via the common 'hot' junction electrode 38 when the 'cold' face electrodes 40 are coupled to an external load such as a rechargeable battery or capacitor. In the arrangement shown in Figure 2, at each end of an interconnected series of pairs of semiconductor blocks 34, 36 the wires 26 connect respective electrodes 40 of the thermoelectric structure 20 to external pins 28 of the integrated circuit package 10. This enables any thermoelectric current to be conducted away from the integrated circuit package 10 for centralised storage or redistribution.

Other types of dissimilar conductor material may be selected to form the thermoelectric structure 20, with differing levels of capability to generate electrical current, according to the Seebeck coefficients of the conductors used. Furthermore, other arrangements of dissimilar conductors, as would be apparent to a person skilled in the relevant art, may be fabricated to generate a required thermoelectric voltage and to cause a flow of thermoelectric current from the structure 20.

By conducting a generated thermoelectric current out of each integrated circuit package via the pins 28 and respective tracks 30 of the printed circuit board 12, the generated energy may be centrally harvested under the control of a single energy harvester from one or more integrated circuit packages 10 according to the present disclosure. In this way, harvested electrical energy may be used to reduce the overall electricity consumption of an electronic circuit incorporating those packages 10 during operation or it may be used to maintain certain functions of the electronic circuit when the circuit's main source of electrical power is disconnected or becomes temporarily unavailable.

In principle, a thermoelectric structure 20 such as that described above may be incorporated into the integrated circuit packaging of any type of integrated circuit, in particular one known to generate a reasonable quantity of heat.

However, in circumstances of overheating, where the conversion of heat to electricity by the thermoelectric structure 20 does not achieve a required level of cooling, the thermoelectric structure 20 may alternatively be used as a Peltier cooling device if an electric current is supplied to the thermoelectric structure 20. A central energy harvester may include a controller configured to receive temperature indications from temperature sensors associated with integrated circuit packages 10 according to the present disclosure. In the event that the sensed temperature of one or more such packages 10 exceeds a predetermined threshold, the controller may be configured temporarily to suspend energy harvesting from that or those integrated circuit packages 10. Instead, the controller may trigger the supply of centrally harvested energy, for example stored energy or electric current being generated by other such integrated circuit packages 10, to the thermoelectric structure 20 in the overheating package 10 to provide temporary thermoelectric cooling. The controller may be configured to use harvested energy at least to supplement another source of electric current if thermoelectric cooling is required to any one integrated circuit package 10.

If the controller triggers a supply of an electric current in an appropriate direction to the connecting pins 28 of an integrated circuit package 10, the supplied current causes a temperature gradient to be thermoelectrically induced in a reverse direction between the first face 22 and the second face 24 of a structure 20. That is, the previously 'hot' face 22 and hot junction electrode 38 becomes a cold face and cold junction electrode able to provide cooling to the adjacent integrated circuit 18. The controller may be configured to resume energy harvesting when the sensed temperature falls below a lower predetermined threshold.

The energy harvester may be implemented as a stand-alone integrated circuit and/or an arrangement of discrete electronic components. The energy harvester may comprise a digital processor arranged to execute a computer program installed from a conventional memory device which when executed by the digital processor causes the digital processor to implement the method of energy harvesting and integrated circuit cooling described above. Alternatively, that method may be implemented by an appropriately configured hardware logic device.

The electrical energy storage device may comprise a rechargeable battery or a capacitor for example.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. An energy harvester connected to receive an electric current output at respective conducting pins (28) of an integrated circuit package (10) by a thermoelectric structure (20) incorporated therein, wherein:
the integrated circuit package (10) comprises: a housing (14); an integrated circuit (18) contained within the housing (14); the thermoelectric structure (20) having a first face (22) arranged in proximity to the integrated circuit (18) within the housing (14) and a second face (24) arranged in thermal contact with ambient conditions; the electrically conducting pins (28) extending outwardly from the housing (14) and connected to the thermoelectric structure (20) within the housing (14) for conducting an electric current generated by the thermoelectric structure (20) for use outside the package (10); and
the energy harvester comprises a controller configured to control a use made of the received electric current;
wherein the controller is configured to determine whether:
(i) to use the received current to recharge an electrical energy storage device; or
(ii) to use the received current as a supplementary source of electric current for operation of the integrated circuit package (10) or for another electronic device; or
(iii) to supply previously stored energy from the electrical energy storage device; and
wherein the controller is configured to receive a sensed temperature indication from a temperature sensor associated with the integrated circuit package (10) and, if the sensed temperature exceeds a predetermined upper limit, to trigger the supply of an electric current to the thermoelectric structure (20) provided in the package (10) via the respective conducting pins (28) and thereby provide cooling of an integrated circuit (18) incorporated within the package (10).

2. The energy harvester according to claim 1, wherein the controller is configured, if the sensed temperature falls below a predetermined lower limit, to receive an electric current output at the respective conducting pins (28).

3. The energy harvester according to claim 1 or claim 2, arranged to receive an electric current from a plurality of integrated circuit packages (10) and wherein the controller is configured to receive respective sensed temperature indications from a temperature sensor associated with at least one of the plurality of integrated circuit packages (10) and to trigger the supply of harvested electrical energy to respective conducting pins (28) of the at least one integrated circuit package (10) if the indicated temperature exceeds the predetermined upper limit.

4. The energy harvester according to any of claims 1 to 3, wherein the thermoelectric structure (20) comprises an arrangement of dissimilar electrically conducting materials of a first and a second type, wherein one or more portions (34, 36) of the first and second types of material extend between the first face (22) and the second face (24) of the structure (20), a portion (34) of the first type of material being electrically coupled at the first face to a portion (36) of the second type of material and the portions (34, 36) being electrically connected (40, 26) directly or indirectly to respective conducting pins (28) at the second face (24).

5. The energy harvester according to any of claims 1 to 4, wherein the first type of material is a *p*-type semiconductor and the second type of material is an *n*-type semiconductor.

6. The energy harvester according to any of claims 1 to 5, wherein two or more pairs of portions (34, 36) of the first and second types of material are connected (40) in series at the second face (24).

7. The energy harvester according to any of claims 1 to 6, wherein two or more pairs of portions (34, 36) of the first and second types of material are connected (40) in parallel at the second face (24).

## Patentansprüche

1. Energie Harvester, angeschlossen zum Erhalten eines elektrischen Stroms, der an jeweiligen leitenden Stiften (28) eines integrierten Schaltungspakets (10) durch eine darin integrierte thermoelektrische Struktur (20) ausgegeben wird, wobei:
das integrierte Schaltungspaket (10) aufweist: ein Gehäuse (14); eine im Gehäuse (14) enthaltene integrierte Schaltung (18); die thermoelektrische Struktur (20) mit einer ersten Seite (22), die nahe der integrierten Schaltung (18) im Gehäuse (14) angeordnet ist, und einer zweiten Seite (24), die in thermischem Kontakt mit Umgebungsbedingungen angeordnet ist; die elektrisch leitenden Stifte (28), die sich aus dem Gehäuse (14) heraus erstrecken und mit der thermoelektrischen Struktur (20) im Gehäuses (14) verbunden sind, zum Leiten eines von der thermoelektrischen Struktur (20) erzeugten elektrischen Stroms zur Verwendung außerhalb des Pakets (10); und
der Energie Harvester eine Steuerung aufweist, die ausgestaltet ist, um eine Verwendung des erhaltenen elektrischen Stroms zu steuern,
wobei die Steuerung ausgestaltet ist, um zu bestimmen, ob:
(i) der erhaltene Strom zum Wiederaufladen einer elektrischen Energiespeichervorrichtung verwendet werden soll; oder
(ii) der erhaltene Strom als zusätzliche elektrische Stromquelle für den Betrieb des integrierten Schaltungspakets (10) oder für ein anderes elektronisches Gerät verwendet werden soll; oder
(iii) eine zuvor gespeicherte Energie von der elektrischen Energiespeichervorrichtung zur Verfügung gestellt werden soll; und
wobei die Steuerung ausgestaltet ist, um eine gemessene Temperaturanzeige von einem Temperatursensor in Verbindung mit dem integrierten Schaltungspaket (10) zu empfangen und, wenn die gemessene Temperatur eine vorbestimmte Obergrenze überschreitet, die Zufuhr eines elektrischen Stroms zu der im Paket (10) vorgesehenen thermoelektrischen Struktur (20) über die jeweiligen leitenden Stifte (28) auszulösen und dadurch ein Kühlen einer im Paket (10) integrierten integrierten Schaltung (18) zu schaffen.

2. Energie Harvester nach Anspruch 1, bei welchem die Steuerung ausgestaltet ist, um, wenn die gemessene Temperatur unter eine vorbestimmte untere Grenze fällt, einen elektrischen Stromausgang an den jeweiligen leitenden Stiften (28) zu erhalten.

3. Energie Harvester nach Anspruch 1 oder Anspruch 2, angeordnet zum Erhalten eines elektrischen Stroms von mehreren integrierten Schaltungspaketen (10), und wobei die Steuerung ausgestaltet ist, um jeweilige gemessene Temperaturanzeigen von einem Temperatursensor in Verbindung mit wenigstens einem der mehreren integrierten Schaltungspakete (10) zu empfangen und die Zufuhr von geernteter elektrischer Energie zu jeweiligen leitenden Stiften (28) des wenigstens einen integrierten Schaltungspakets (10) auszulösen, wenn die angegebene Temperatur die vorbestimmte Obergrenze überschreitet.

4. Energie Harvester nach einem der Ansprüche 1 bis 3, bei welchem die thermoelektrische Struktur (20) eine Anordnung von ungleichen elektrisch leitenden Materialien eines ersten und eines zweiten Typs aufweist, wobei sich ein oder mehrere Teile (34, 36) des ersten und des zweiten Materialtyps zwischen der ersten Seite (22) und der zweiten Seite (24) der Struktur (20) erstrecken, wobei ein Teil (34) des ersten Materialtyps an der ersten Seite elektrisch mit einem Teil (36) des zweiten Materialtyps gekoppelt ist und die Teile (34, 36) direkt oder indirekt mit jeweiligen leitenden Stiften (28) an der zweiten Seite (24) elektrisch verbunden sind (40, 26).

5. Energy Harvester nach einem der Ansprüche 1 bis 4, bei welchem der erste Materialtyp ein Halbleiter vom p-Typ ist und der zweite Materialtyp ein Halbleiter vom n-Typ ist.

6. Energy Harvester nach einem der Ansprüche 1 bis 5, bei welchem zwei oder mehr Paare von Teilen (34, 36) des ersten und es zweiten Materialtyps an der zweiten Seite (24) in Reihe geschaltet sind (40).

7. Energy Harvester nach einem der Ansprüche 1 bis 6, bei welchem zwei oder mehr Paare von Teilen (34, 36) des ersten und des zweiten Materialtyps an der zweiten Seite (24) parallel geschaltet sind (40).

## Revendications

1. Récupérateur d'énergie connecté pour recevoir un courant électrique qui est délivré au niveau de broches conductrices respectives (28) d'un module de circuit intégré (10) par une structure thermoélectrique (20) incorporée à l'intérieur, dans lequel :
le module de circuit intégré (10) comprend : un boîtier (14) ; un circuit intégré (18) qui est contenu à l'intérieur du boîtier (14) ; la structure thermoélectrique (20) qui a une première face (22) disposée à proximité du circuit intégré (18) à l'intérieur du boîtier (14) et une deuxième face (24) disposée en contact thermique avec des conditions ambiantes ; les broches électriquement conductrices (28) qui s'étendent vers l'extérieur depuis le boîtier (14) et sont connectées à la structure thermoélectrique (20) à l'intérieur du boîtier (14) pour conduire un courant électrique généré par la structure thermoélectrique (20) et destiné à être utilisé à l'extérieur du module (10) ; et
le récupérateur d'énergie comprend un contrôleur qui est configuré de manière à contrôler une utilisation faite du courant électrique reçu ;
dans lequel le contrôleur est configuré de manière à déterminer si :
(i) le courant reçu est à être utilisé pour recharger un dispositif de stockage d'énergie électrique ; ou
(ii) le courant reçu est à être utilisé en tant que source additionnelle de courant électrique pour l'opération du module de circuit intégré (10) ou pour un autre dispositif électronique ; ou
(iii) une énergie précédemment stockée à partir du dispositif de stockage d'énergie électrique est à être fournie ; et
dans lequel le contrôleur est configuré de manière à recevoir une indication de température détectée issue d'un détecteur de température associé au module de circuit intégré (10) et, si la température détectée dépasse une limite supérieure prédéterminée, de manière à déclencher la délivrance d'un courant électrique, par le biais des broches conductrices respectives (28), à la structure thermoélectrique (20) disposée dans le module (10) et de manière à ainsi assurer un refroidissement d'un circuit intégré (18) incorporé dans le module (10).

2. Récupérateur d'énergie selon la revendication 1, dans lequel le contrôleur est configuré, si la température détectée tombe en dessous d'une limite inférieure prédéterminée, de manière à recevoir un courant électrique délivré au niveau des broches conductrices respectives (28).

3. Récupérateur d'énergie selon la revendication 1 ou 2, agencé pour recevoir un courant électrique provenant d'une pluralité de modules de circuit intégré (10) et dans lequel le contrôleur est configuré de manière à recevoir des indications de température détectée respectives d'un capteur de température associé à au moins l'un de la pluralité de modules de circuits intégrés (10), et de manière à déclencher la délivrance d'énergie électrique récupérée à des broches conductrices respectives (28) dudit au moins un module de circuit intégré (10) si la température indiquée dépasse la limite supérieure prédéterminée.

4. Récupérateur d'énergie selon l'une quelconque des revendications 1 à 3, dans lequel la structure thermoélectrique (20) comprend un agencement de différents matériaux électriquement conducteurs d'un premier et deuxième type, dans lequel une ou plusieurs parties (34, 36) des premier et deuxième types de matériau s'étendent entre la première face (22) et la deuxième face (24) de la structure (20), une partie (34) du premier type de matériau étant électriquement couplée, au niveau de la première face, à une partie (36) du deuxième type de matériau, et les parties (34, 36) étant électriquement connectées (40, 26) de manière directe ou indirecte aux broches conductrices respectives (28) au niveau de la deuxième face (24).

5. Récupérateur d'énergie selon l'une quelconque des revendications 1 à 4, dans lequel le premier type de matériau est un semi-conducteur de type p et le deuxième type de matériau est un semi-conducteur de type n.

6. Récupérateur d'énergie selon l'une quelconque des revendications 1 à 5, dans lequel deux ou plusieurs paires de parties (34, 36) des premier et deuxième types de matériau sont connectées (40) en série au niveau de la deuxième face (24).

7. Récupérateur d'énergie selon l'une quelconque des revendications 1 à 6, dans lequel deux ou plusieurs paires de parties (34, 36) des premier et deuxième types de matériau sont connectées (40) en parallèle au niveau de la deuxième face (24).
